# EUROPEAN PATENT APPLICATION

(11) **EP 4 518 625 A1**
(43) Date of publication of application: **05.03.2025**
(21) Application number: 24192488.5
(22) Date of filing: 02.08.2024
(51) Int. Cl.: H10K 59/122, H10K 59/124, H10K 59/131, H10K 59/80

(54) **DISPLAY DEVICE**

(30) Priority: 28.08.2023 JP 2023138098
(71) Applicant: Japan Display Inc., Tokyo 105-0003 (JP)
(72) Inventor: HARADA, Kazuyuki, Tokyo, 105-0003 (JP); TABATAKE, Hiroshi, Tokyo, 105-0003 (JP); TAKAHASHI, Hideyuki, Tokyo, 105-0003 (JP); FUJIMOTO, Takamitsu, Tokyo, 105-0003 (JP)
(74) Representative: MERH-IP Matias Erny Reichl Hoffmann Patentanwälte PartG mbB

(57) **Abstract**

According to one embodiment, a display device (DSP) includes (6) a partition which is provided between each adjacent pair of display elements (DE1, DE2, DE3) in a display area (DA), an electrode layer (21) provided in a surrounding area (SA), a conductive layer (60) provided above the electrode layer (69), and an inorganic insulating layer (50) provided between the electrode layer and the conductive layer(21). The partition (6) and the conductive layer (60) include a conductive lower portion (61) and an upper portion (62) which protrudes from side surfaces of the lower portion (61). The electrode layer (21) includes an electrode aperture (23) penetrating in a stacking direction. The conductive layer (60) overlaps with the electrode aperture (23).

## Description

### FIELD

Embodiments described herein relate generally to a display device.

### BACKGROUND

Recently, display devices with organic light emitting diodes (OLED) applied thereto as display elements have been put into practical use. This display device comprises a lower electrode, an organic layer covering the lower electrode, and an upper electrode covering the organic layer.

When such a display device is manufactured, a technique of improving the yield in the manufacturing process is required.

### BRIEF DESCRIPTION OF THE DRAWINGS

FIG. 1 is a view showing a configuration example of a display device according to an embodiment.
FIG. 2 is a schematic plan view showing an example of the layout of subpixels.
FIG. 3 is a schematic cross-sectional view of the display device along the III-III line of FIG. 2.
FIG. 4 is a view showing an example of a layer structure applicable to organic layers.
FIG. 5 is a schematic enlarged plan view showing several parts of the display device.
FIG. 6 is a schematic cross-sectional view showing the display device along the VI-VI line in FIG. 5.
FIG. 7 is a schematic cross-sectional view showing the display device along the VII-VII line in FIG. 5.
FIG. 8 is a schematic cross-sectional view showing the display device along the VIII-VIII line in FIG. 5.
FIG. 9 is a schematic cross-sectional view showing a display device according to a comparative example.

### DETAILED DESCRIPTION

In general, according to one embodiment, a display device includes a display area where a plurality of display elements are arranged, and a surrounding area around the display area. The display device includes a partition which is provided between each adjacent pair of display elements in the display area, an electrode layer provided in the surrounding area, a conductive layer provided above the electrode layer, and an inorganic insulating layer provided between the electrode layer and the conductive layer.

The partition and the conductive layer include a conductive lower portion and an upper portion which protrudes from side surfaces of the lower portion. The electrode layer includes an electrode aperture penetrating in a stacking direction. The conductive layer overlaps with the electrode aperture.

According to another embodiment, a display device includes a display area where a plurality of display elements are provided, and a surrounding area around the display area. The display device includes a partition which is provided between each adjacent pair of display elements in the display area, an electrode layer provided in the surrounding area, a conductive layer provided above the electrode layer, and an inorganic insulating layer provided between the electrode layer and the conductive layer.

The partition and the conductive layer include a conductive lower portion and an upper portion which protrudes from side surfaces of the lower portion. The conductive layer includes a conductive aperture penetrating in a stacking direction. The electrode layer overlaps with the conductive aperture.

According to yet another embodiment, a display device includes a display area where a plurality of display elements are arranged, and a surrounding area around the display area. The display device includes a partition which is provided between each adjacent pair of display elements in the display area, a first organic insulating layer provided in the surrounding area, an electrode layer provided above the first organic insulating layer, and an inorganic insulating layer provided above the electrode layer.

The partition includes a conductive lower portion and an upper portion which protrudes from side surfaces of the lower portion. The first organic insulating layer has an inclined surface located at an end portion of the first organic insulating layer. The electrode layer includes an electrode aperture penetrating in a stacking direction and overlapping with the inclined surface.

According to the configuration, a display device capable of improving the yield in the manufacturing process can be provided.

Embodiments will be described hereinafter with reference to the accompanying drawings.

The disclosure is merely an example, and proper changes within the spirit of the invention, which are easily conceivable by a person of ordinary skill in the art, are included in the scope of the invention as a matter of course. In addition, in some cases, in order to make the description clearer, the widths, thicknesses, shapes and the like, of the respective parts are schematically illustrated in the drawings, compared to the actual modes. However, the schematic illustration is merely an example, and adds no restriction to the interpretation of the invention. In addition, in the specification and drawings, structural elements which function in the same or a similar manner to those described in connection with preceding drawings are denoted by like reference numbers, detailed description thereof being omitted unless necessary.

In the drawings, an X-axis, a Y-axis and a Z-axis orthogonal to each other are described to facilitate understanding as needed. A direction along the X-axis is referred to as an X-direction, a direction along the Y-axis is referred to as a Y-direction, and a direction along the Z-axis is referred to as a Z-direction. The Z-direction is a normal of a plane including the X-direction and the Y-direction. In the embodiment, the Z-direction corresponds to a stacking direction. In addition, viewing various elements parallel to the Z-direction is referred to as plan view.

The display device of the embodiment is an organic electroluminescent display device comprising an organic light emitting diode (OLED) as a display element, and can be mounted on various electronic devices such as televisions, personal computers, vehicle-mounted devices, tablet terminals, smartphones, mobile phones, and wearable terminals.

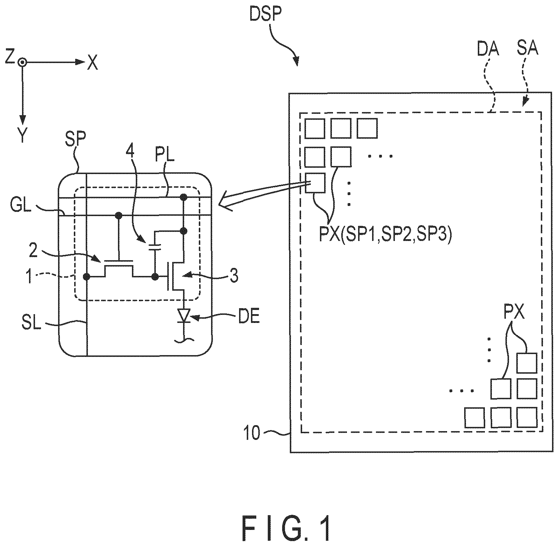

FIG. 1 is a view showing a configuration example of a display device DSP according to the embodiment. The display device DSP comprises an insulating substrate 10. The substrate 10 has a display area DA where images are displayed, and a surrounding area SA around the display area DA. A plurality of display elements to be described below are provided in the display area DA. The substrate 10 may be glass or a resin film having flexibility.

In the embodiment, the shape of the substrate 10 in plan view is a rectangular shape. However, the shape of the substrate 10 in plan view is not limited to a rectangular shape, but may be any other shape such as a square, a circle or an ellipse.

The display area DA includes a plurality of pixels PX arrayed in a matrix in the X-direction and the Y-direction. Each pixel PX includes a plurality of subpixels SP that display different colors. It is assumed in this embodiment that each pixel PX includes a blue subpixel SP1, a green subpixel SP2, and a red subpixel SP3. However, each pixel PX may include a subpixel SP which exhibits the other color such as white in addition to the subpixels SP1, SP2 and SP3 or instead of one of subpixels SP1, SP2 and SP3.

The subpixel SP comprises a pixel circuit 1 and a display element DE driven by the pixel circuit 1. The pixel circuit 1 comprises a pixel switch 2, a drive transistor 3, and a capacitor 4. The pixel switch 2 and the drive transistor 3 are, for example, switching elements constituted by thin-film transistors.

A plurality of scanning lines GL which supply a scanning signal to the pixel circuit 1 of each subpixel SP, a plurality of signal lines SL which supply a video signal to the pixel circuit 1 of each subpixel SP, and a plurality of power lines PL, are provided in the display area DA. In the example shown in FIG. 1, the scanning lines GL and the power lines PL extend in the X-direction, and the signal lines SL extend in the Y-direction.

A gate electrode of the pixel switch 2 is connected to a scanning line GL. One of a source electrode and a drain electrode of the pixel switch 2 is connected to the signal line SL, and the other is connected to a gate electrode of the drive transistor 3 and the capacitor 4. In the drive transistor 3, one of the source electrode and the drain electrode is connected to the power line PL and the capacitor 4, and the other is connected to the display element DE.

Incidentally, the configuration of the pixel circuit 1 is not limited to the example shown in the drawing. For example, the pixel circuit 1 may comprise more thin-film transistors and more capacitors.

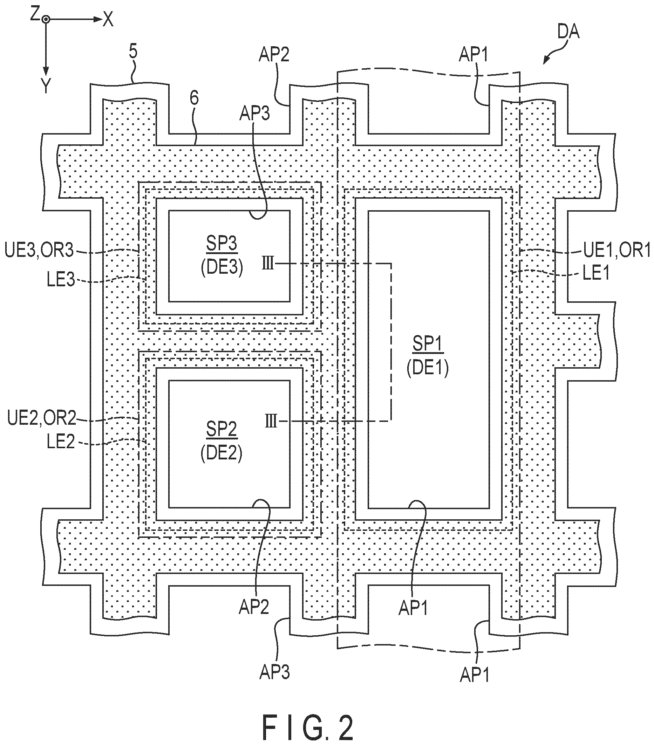

FIG. 2 is a schematic plan view showing an example of a layout of the subpixels SP1, SP2, and SP3. In the example shown in FIG. 2, each of the subpixels SP2 and SP3 is adjacent to the subpixel SP1 in the X-direction. Furthermore, the subpixel SP2 and the subpixel SP3 are arranged in the Y-direction.

When the subpixels SP1, SP2, and SP3 are provided in line with this layout, a column in which the subpixels SP2 and SP3 are alternately provided in the Y-direction and a column in which a plurality of subpixels SP1 are repeatedly provided in the Y-direction are formed, in the display area DA. These columns are alternately arranged in the X-direction. Incidentally, the layout of the subpixels SP1, SP2, and SP3 is not limited to the example shown in FIG. 2.

A rib 5 is arranged in the display area DA. The rib 5 includes pixel apertures AP1, AP2, and AP3 in the subpixels SP1, SP2, and SP3, respectively. In the example shown in FIG. 2, the pixel aperture AP1 is larger than the pixel aperture AP2, and the pixel aperture AP2 is larger than the pixel aperture AP3. Thus, among the subpixels SP1, SP2 and SP3, the aperture ratio of the subpixel SP1 is the greatest, and the aperture ratio of the subpixel SP3 is the least.

The subpixel SP1 comprises a lower electrode LE1, an upper electrode UE1, and an organic layer OR1 each overlapping with the pixel aperture AP1. The subpixel SP2 comprises a lower electrode LE2, an upper electrode UE2, and an organic layer OR2 each overlapping with the pixel aperture AP2. The subpixel SP3 comprises a lower electrode LE3, an upper electrode UE3, and an organic layer OR3 each overlapping with the pixel aperture AP3.

The parts of the lower electrode LE1, the upper electrode UE1, and the organic layer OR1, which overlap with the pixel aperture AP1, constitute the display element DE1 of the subpixel SP1. The parts of the lower electrode LE2, the upper electrode UE2, and the organic layer OR2, which overlap with the pixel aperture AP2, constitute the display element DE2 of the subpixel SP2. The parts of the lower electrode LE3, the upper electrode UE3, and the organic layer OR3, which overlap with the pixel aperture AP3, constitute the display element DE3 of the subpixel SP3. The display elements DE1, DE2, and DE3 may further include a cap layer to be described below.

A conductive partition 6 is provided in the display area DA. The partition 6 is provided on the rib 5. The partition 6 entirely overlaps with the rib 5 and has the same planar shape as the rib 5. The partition 6 is provided between each adjacent pair of display elements DE1, DE2, and DE3.

In other words, the partition 6 includes an aperture in each of the subpixels SP1, SP2, and SP3. From another viewpoint, each of the rib 5 and the partition 6 has a grating shape as seen in plan view and surrounds each of subpixels SP1, SP2 and SP3. The partition 6 functions as lines which supply a common voltage to the upper electrodes UE1, UE2 and UE3.

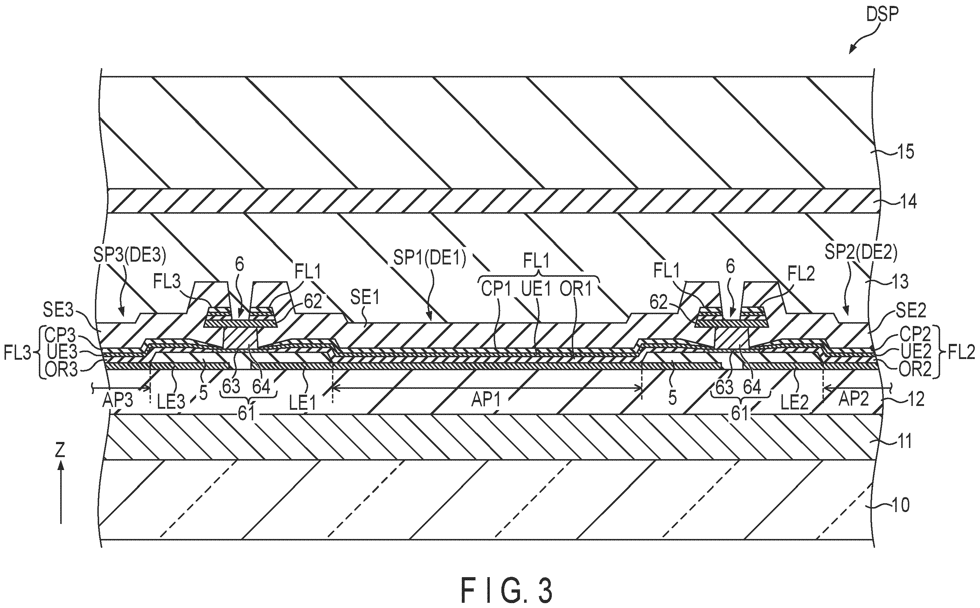

FIG. 3 is a schematic cross-sectional view of the display device DSP along the III-III line of FIG. 2. A circuit layer 11 is provided on the substrate 10 described above. The circuit layer 11 includes various circuits and lines such as the pixel circuits 1, the scanning lines GL, the signal lines SL, and the power lines PL shown in FIG. 1. The circuit layer 11 is covered with an organic insulating layer 12. The organic insulating layer 12 functions as a planarization film which planarizes uneven parts formed by the circuit layer 11.

The lower electrodes LE1, LE2, and LE3 are provided on the organic insulating layer 12. The rib 5 is provided on the organic insulating layer 12 and the lower electrodes LE1, LE 2, and LE3. End parts of the lower electrodes LE1, LE2, and LE3 are covered with the rib 5.

Although not shown in the section of FIG. 3, the lower electrodes LE1, LE2 and LE3 are connected to the pixel circuits 1 of the circuit layer 11 through respective contact holes provided in the organic insulating layer 12.

The partition 6 includes a conductive lower portion 61 provided on the rib 5 and an upper portion 62 provided on the lower portion 61. The upper portion 62 has a width greater than that of the lower portion 61. Accordingly, the both end parts of the upper portion 62 protrude beyond the side surfaces of the lower portion 61. This shape of the partition 6 is referred to as an overhang shape.

In the example shown in FIG. 3, the lower portion 61 includes a bottom layer 63 provided on the rib 5, and a stem layer 64 provided on the bottom layer 63. For example, the bottom layer 63 is formed so as to be thinner than the stem layer 64. In addition, in the example shown in FIG. 3, the both end portions of the bottom layer 63 protrude from the side surfaces of the stem layer 64.

The organic layer OR1 covers the lower electrode LE1 through the pixel aperture AP1. The upper electrode UE1 covers the organic layer OR1 and faces the lower electrode LE1. The organic layer OR1 is provided between the lower electrode LE1 and the upper electrode UE1.

The organic layer OR2 covers the lower electrode LE2 through the pixel aperture AP2. The upper electrode UE2 covers the organic layer OR2 and faces the lower electrode LE2. The organic layer OR3 covers the lower electrode LE3 through the pixel aperture AP3. The upper electrode UE3 covers the organic layer OR3 and faces the lower electrode LE3. The upper electrodes UE1, UE2, and UE3 are in contact with side surfaces of the lower portion 61 of the partition 6.

The display element DE1 includes a cap layer CP1 provided on the upper electrode UE1. The display element DE2 includes a cap layer CP2 provided on the upper electrode UE2. The display element DE3 includes a cap layer CP3 provided on the upper electrode UE3. The cap layers CP1, CP2, and CP3 function as optical adjustment layers for improving the outcoupling efficiency of the light emitted from the organic layers OR1, OR2, and OR3, respectively.

In the following descriptions, a multilayer body including the organic layer OR1, the upper electrode UE1, and the cap layer CP1 is referred to as a multilayer film FL1, a multilayer body including the organic layer OR2, the upper electrode UE2, and the cap layer CP2 is referred to as a multilayer film FL2, and a multilayer body including the organic layer OR3, the upper electrode UE3, and the cap layer CP3 is referred to as a multilayer film FL3.

A part of the multilayer film FL1 is located on the upper portion 62. This part is separated from a portion of the multilayer film FL1, which is located under the partition 6 (i.e., a portion constituting the display element DE1). Similarly, a part of the multilayer film FL2 is located on the upper portion 62, and this part is separated from a portion of the multilayer film FL2, which is located under the partition 6 (i.e., a portion constituting the display element DE2). Furthermore, a part of the multilayer film FL3 is located on the upper portion 62, and this part is separated from a portion of the multilayer film FL3, which is located under the partition 6 (i.e., a portion constituting the display element DE3).

Sealing layers SE1, SE2, and SE3 are provided in the subpixels SP1, SP2 and SP3, respectively. The sealing layer SE1 continuously covers the cap layer CP1 and the partition 6 around the subpixel SP1. The sealing layer SE2 continuously covers the cap layer CP2 and the partition 6 around the subpixel SP2. The sealing layer SE3 continuously covers the cap layer CP3 and the partition 6 around the subpixel SP3.

In the example shown in FIG. 3, the multilayer film FL1 and the sealing layer SE1 on the partition 6 between the subpixels SP1 and SP2 are separated from the multilayer film FL2 and the sealing layer SE2 on the partition 6. In addition, the multilayer film FL1 and the sealing layer SE1 on the partition 6 between the subpixels SP1 and SP3 are separated from the multilayer film FL3 and the sealing layer SE3 on the partition 6.

The sealing layers SE1, SE2, and SE3 are covered with a resin layer 13. The resin layer 13 is covered with a sealing layer 14. The sealing layer 14 is covered with a resin layer 15. The resin layers 13 and 15 and the sealing layer 14 are provided continuously on a whole body of at least the display area DA, and partially extend to the surrounding area SA.

A cover member such as a polarizer, a touch panel, a protective film or a cover glass may be further provided above the resin layer 15. Such a cover member may be adhered to the resin layer 15 via, for example, an adhesive layer such as an optical clear adhesive (OCA) .

The organic insulating layer 12 is formed of an organic insulating material such as polyimide. The rib 5 and the sealing layers 14, SE1, SE2, and SE3 are formed of an inorganic insulating material such as silicon nitride (SiNx), silicon oxide (SiOx), silicon oxynitride (SiON) or aluminum oxide (Al₂O₃). In one example, the rib 5 is formed of silicon oxynitride and the sealing layers 14, SE1, SE2, and SE3 are formed of silicon nitride. The resin layers 13 and 15 are formed of, for example, a resin material (organic insulating material) such as epoxy resin or acrylic resin.

Each of the lower electrodes LE1, LE2 and LE3 includes a reflective layer formed of, for example, silver, and a pair of conductive oxide layers covering the upper and lower surfaces of the reflective layer. Each of the conductive oxide layers can be formed of, for example, a transparent conductive oxide such as indium tin oxide (ITO), indium zinc oxide (IZO), or indium gallium zinc oxide (IGZO).

The upper electrodes UE1, UE2, and UE3 are formed of, for example, a metal material such as an alloy (MgAg) of magnesium and silver. For example, the lower electrodes LE1, LE2, and LE3 correspond to anodes, and the upper electrodes UE1, UE2, and UE3 correspond to cathodes.

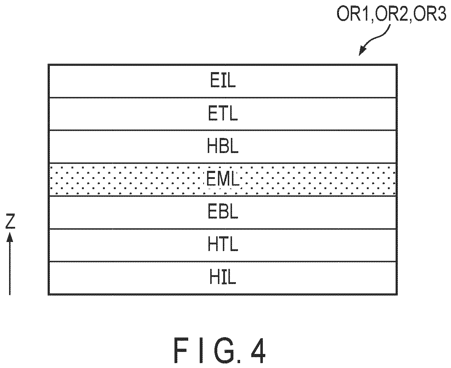

FIG. 4 is a diagram showing an example of a layer structure applicable to the organic layers OR1, OR2, and OR3. Each of the organic layers OR1, OR2 and OR3 is formed of a plurality of thin films including a light emitting layer EML. In the present embodiment, it is assumed that each of the organic layers OR1, OR2, and OR3 has a structure in which, for example, a hole injection layer HIL, a hole transport layer HTL, an electron blocking layer EBL, a light emitting layer EML, a hole blocking layer HBL, an electron transport layer ETL, and an electron injection layer EIL are stacked in this order in the Z direction. However, the organic layers OR1, OR2, and OR3 may have the other structure such as a so-called tandem structure including a plurality of light emitting layers EML.

Each of the cap layers CP1, CP2, and CP3 has, for example, a multilayer structure in which a plurality of transparent layers are stacked. These transparent layers may include a layer formed of an inorganic material and a layer formed of an organic material. In addition, these transparent layers have refractive indices different from each other.

For example, the refractive indices of these transparent layers are different from the refractive indices of the upper electrodes UE1, UE2 and UE3 and the refractive indices of the sealing layers SE1, SE2, and SE3. Incidentally, at least one of the cap layers CP1, CP2, and CP3 may be omitted.

Each of the bottom layer 63 and stem layer 64 of the partition 6 is formed of a metal material. For the metal material of the bottom layer 63, for example, molybdenum, titanium, titanium nitride (TiN), a molybdenum-tungsten alloy (MoW) or a molybdenum-niobium alloy (MoNb) can be used.

For the metal material of the stem layer 64, for example, aluminum, an aluminum-neodymium alloy (AlNd), an aluminum-yttrium alloy (AlY) or an aluminum-silicon alloy (AlSi) can be used. Incidentally, the stem layer 64 may be formed of an insulating material.

For example, the upper portion 62 of the partition 6 has a multilayer structure consisting of a lower layer formed of a metal material and an upper layer formed of conductive oxide. For example, titanium, titanium nitride, molybdenum, tungsten, a molybdenum-tungsten alloy or a molybdenum-niobium alloy can be used as the metal material for forming the lower layer. For example, ITO or IZO can be used as the conductive oxide for forming the upper layer. Incidentally, the upper portion 62 may have a single-layer structure of a metal material. The upper portion 62 may further include a layer formed of an insulating material.

A common voltage is supplied to the partition 6. This common voltage is supplied to each of the upper electrodes UE1, UE2, and UE3 that are in contact with the side surfaces of the lower portion 61. Pixel voltage is applied to the lower electrodes LE1, LE2 and LE3 through the pixel circuits 1 provided in the subpixels SP1, SP2 and SP3, respectively, based on the video signals of the signal lines SL.

The organic layers OR1, OR2, and OR3 emit light in response to the application of a voltage. More specifically, when a potential difference is formed between the lower electrode LE1 and the upper electrode UE1, the light emitting layer EML of the organic layer OR1 emits light in a blue wavelength range. When a potential difference is formed between the lower electrode LE2 and the upper electrode UE2, the light emitting layer EML of the organic layer OR2 emits light in a green wavelength range. When a potential difference is formed between the lower electrode LE3 and the upper electrode UE3, the light emitting layer EML of the organic layer OR3 emits light in a red wavelength range.

As another example, the light emitting layers EML of the organic layers OR1, OR2, and OR3 may emit light exhibiting the same color (for example, white). In this case, the display device DSP may comprise color filters which convert the light emitted from the light emitting layers EML into light exhibiting the colors corresponding to the subpixels SP1, SP2, and SP3. In addition, the display device DSP may comprise a layer including quantum dots which generate light exhibiting colors corresponding to the subpixels SP1, SP2 and SP3 by the excitation caused by the light emitted from the light emitting layers EML.

Next, a structure which can be applied to the surrounding area SA will be described.

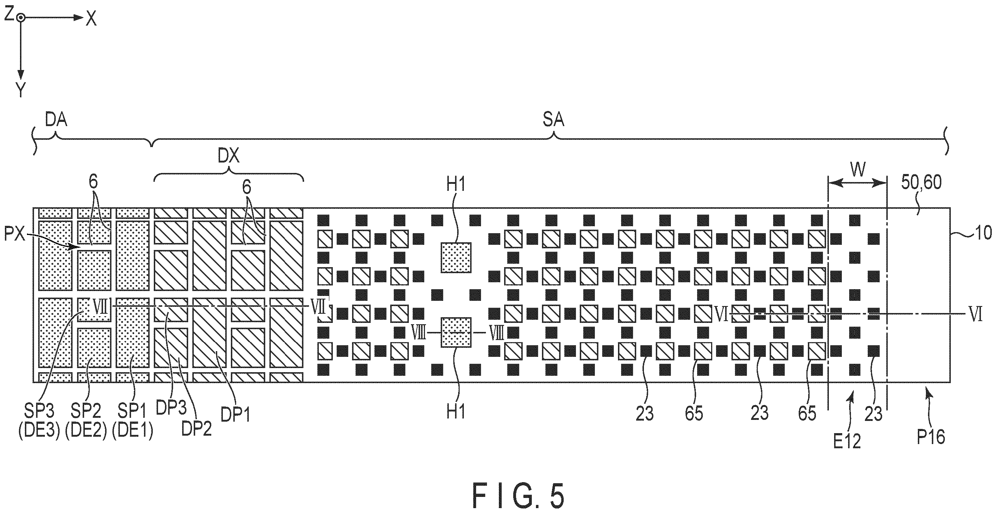

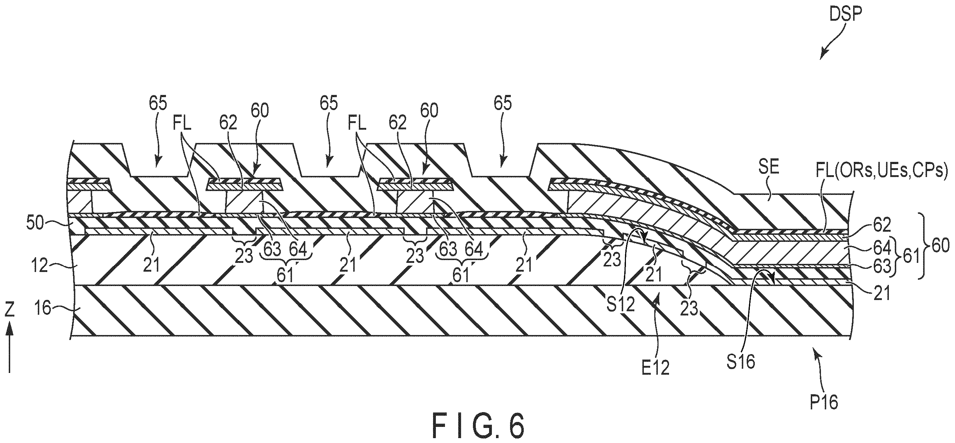

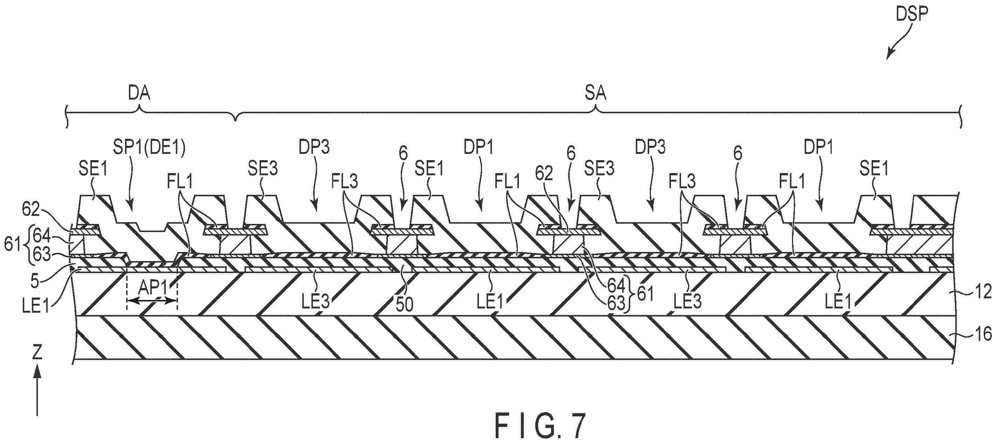

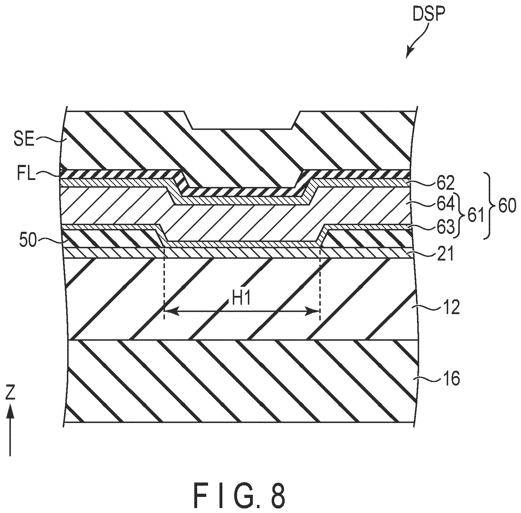

FIG. 5 is a schematic enlarged plan view showing several parts of the display device DSP. FIG. 6 is a schematic cross-sectional view showing the display device DSP along the VI-VI line shown in FIG. 5. FIG. 7 is a schematic cross-sectional view showing the display device DSP along the VII-VII line shown in FIG. 5. FIG. 8 is a schematic cross-sectional view showing the display device DSP along the VIII-VIII line shown in FIG. 5.

FIG. 5 shows several part s of the display area DA and the surrounding area SA in the vicinity of the end portion of the substrate 10. In FIG. 6 and the subsequent drawings, the substrate 10, the resin layers 13 and 15, the sealing layer 14, and the like are omitted.

The substrate 10 includes the display area DA and the surrounding area SA as shown in FIG. 5. The display area DA includes a plurality of pixels PX including the subpixels SP1, SP2, and SP3. The partition 6 is provided between each adjacent pair of display elements DE1, DE2, and DE3.

The display device DSP includes the organic insulating layers 12 and 16, an electrode layer 21, an inorganic insulating layer 50, a conductive layer 60, a multilayer film FL, and a sealing layer SE as shown in FIG. 6. In the present embodiment, the organic insulating layer 16 corresponds to a second organic insulating layer, and the organic insulating layer 12 corresponds to a first organic insulating layer.

In FIG. 5, portions of the display area DA where the rib 5 is not formed are represented by dots. In FIG. 5, portions where the inorganic insulating layer 50 is not formed are represented by dots, and portions where the conductive layer 60 is not formed are represented by hatch lines, in the surrounding area SA. In addition, in FIG. 5, portions where the electrode layer 21 is not formed are used as electrode apertures 23 and are colored in black, in the surrounding area SA other than an area where a plurality of dummy pixels DX to be described below are formed.

The organic insulating layer 16 is one of a plurality of elements constituting the circuit layer 11 (shown in FIG. 3). The organic insulating layer 16 is formed of, for example, an organic insulating material. The organic insulating layers 12 and 16 are provided over the display area DA and the surrounding area SA. The organic insulating layer 16 is provided under the organic insulating layer 12.

The electrode layer 21 is provided in the surrounding area SA. The electrode layer 21 is provided on the organic insulating layer 12. For example, the electrode layer 21 is formed of the same material by the same manufacturing process as the lower electrodes LE1, LE2, and LE3 in the display area DA.

The inorganic insulating layer 50 is provided between the electrode layer 21 and the conductive layer 60. The inorganic insulating layer 50 is formed of the same material by the same manufacturing process as the rib 5 in the display area DA. The inorganic insulating layer 50 is connected to the rib 5 provided in the display area DA.

The conductive layer 60 is provided above the electrode layer 21. When the electrode layer 21 is focused, the organic insulating layers 12 and 16 are provided under the electrode layer 21, and the inorganic insulating layer 50 is provided above the electrode layer 21.

The conductive layer 60 is formed of the same material by the same manufacturing process as the partition 6 in the display area DA. The conductive layer 60 is connected to the partition 6 provided in the display area DA.

Similarly to the partition 6 (shown in FIG. 3), the conductive layer 60 includes a conductive lower portion 61 and an upper portion 62 which protrudes from side surfaces of the lower portion 61. The lower portion 61 includes a bottom layer 63 provided on the inorganic insulating layer 50, and a stem layer 64 provided on the bottom layer 63. For example, the bottom layer 63 is formed so as to be thinner than the stem layer 64. In addition, for example, the both end portions of the bottom layer 63 protrude from the side surfaces of the stem layer 64.

An organic layer ORs, an upper electrode UEs, and a cap layer CPs are provided in the multilayer film FL. The organic layer ORs is formed of the same material by the same manufacturing process as one of the organic layers OR1, OR2, and OR3. The upper electrode UEs is formed of the same material by the same manufacturing process as one of the upper electrodes UE1, UE2, and UE3.

The cap layer CPs is formed of the same material by the same manufacturing process as one of the cap layers CP1, CP2, and CP3. In one example, the organic layer ORs, the upper electrode UEs, and the cap layer CPs are formed of the same material by the same manufacturing process as the organic layer OR3, the upper electrode UE3, and the cap layer CP3, respectively.

The sealing layer SE is formed of the same material by the same manufacturing process as one of the sealing layers SE1, SE2, and SE3. In one example, the sealing layer SE is formed of the same material by the same manufacturing process as the sealing layer SE3. The multilayer film FL and the sealing layer SE overlap with the conductive layer 60 in plan view.

The organic insulating layer 12 includes an end portion E12 as shown in FIG. 6. The end portion E12 is formed in, for example, a frame shape surrounding the display area DA in plan view. The end portion E12 is covered with the electrode layer 21. An inclined surface S12 is located at the end portion E12. In other words, the organic insulating layer 12 has the inclined surface S12 located at the end portion E12.

The inclined surface S12 corresponds to a part of a surface facing the electrode layer 21. The inclined surface S12 is inclined to be closer to the organic insulating layer 16 as its distance from the display area DA is longer. In other words, a thickness of the organic insulating layer 12 at the end portion E12 is smaller as its distance from the display area DA is longer.

The inclined surface S12 is curved in the example shown in FIG. 6. However, the inclined surface S12 may not be curved. A width W (shown in FIG. 5) of the inclined surface S12 is, for example, approximately 50 um.

As shown in FIG. 6, the organic insulating layer 16 further protrudes than the end portion E12 of the organic insulating layer 12 in the surrounding area SA. More specifically, the organic insulating layer 16 includes a portion P16 further protruding than the end portion E12. An upper surface S16 of the portion P16 is covered with the electrode layer 21.

The upper surface S16 corresponds to a part of a surface facing the organic insulating layer 12. The inorganic insulating layer 50, the conductive layer 60, the multilayer film FL, and the sealing layer SE are further stacked on the electrode layer 21 covering the portion P16.

The electrode layer 21 includes a plurality of electrode apertures 23 as shown in FIG. 5. The electrode apertures 23 function as apertures for releasing moisture from the organic insulating layer 12, for example, after the formation of the electrode layer 21.

The plurality of electrode apertures 23 penetrate the electrode layer 21 in the Z-direction as shown in FIG. 6. The conductive layer 60 overlaps with the electrode apertures 23 in plan view. In other words, the conductive layer 60 is provided above the electrode apertures 23.

More specifically, the lower portion 61 of the conductive layer 60 is provided above the electrode apertures 23. More specifically, the stem layer 64 of the conductive layer 60 is provided above the electrode apertures 23. Several parts of the inorganic insulating layer 50 are located at the electrode apertures 23.

When the inclined surface S12 is focused, the electrode apertures 23 overlap with the inclined surface S12 in plan view. In other words, the electrode apertures 23 are also formed in the area overlapping with the inclined surface S12 in plan view.

In addition, the conductive layer 60 also overlaps with the electrode apertures 23 overlapping with the inclined surface S12 in plan view. The electrode apertures 23 are not formed in the area overlapping with the portion P16 of the organic insulating layer 16 in plan view.

The electrode apertures 23 have a quadrangular shape in plan view in the example shown in FIG. 5. In this case, the quadrangular shape implies a rectangular shape and a square shape. In the other examples, the electrode apertures 23 may have a circular shape, an elliptical shape, or the other polygonal shape.

In the example shown in FIG. 5, a width (for example, a length in the Y-direction) of the electrode aperture 23 is smaller than a distance between two conductive apertures 65. More specifically, the width of the electrode aperture 23 is smaller than the width of the lower portion 61 of the conductive layer 60 in the example shown in FIG. 6. More specifically, the width of the electrode aperture 23 is smaller than the width of the stem layer 64 of the conductive layer 60 in the example shown in FIG. 6.

The conductive layer 60 includes a plurality of conductive apertures 65 as shown in FIG. 5. The plurality of conductive apertures 65 penetrate the conductive layer 60 in the Z-direction as shown in FIG. 6. The electrode layer 21 overlaps with the conductive apertures 65 in plan view. In addition, the electrode apertures 23 do not overlap with the conductive apertures 65 in plan view.

When the inclined surface S12 is focused, the conductive apertures 65 do not overlap with the inclined surface S12 in plan view. In other words, the conductive apertures 65 are not formed in the area overlapping with the inclined surface S12 in plan view.

The conductive apertures 65 have a quadrangular shape in plan view in the example shown in FIG. 5. In the other examples, the electrode apertures 23 may have a circular shape, an elliptical shape, or the other polygonal shape.

The conductive aperture 65 is larger than, for example, the electrode aperture 23 in plan view. Incidentally, the conductive aperture 65 may be smaller than the electrode aperture 23 or may have the same size as the electrode aperture 23 in plan view.

A part of the multilayer film FL is located at the conductive aperture 65. The portion of the multilayer film FL, which is located on the conductive layer 60, is spaced apart from the portion of the multilayer film FL, which is located under the conductive layer 60.

The sealing layer SE is provided above the conductive layer 60 and the conductive apertures 65 as shown in FIG. 6. In other words, parts of the sealing layer SE are located at the conductive apertures 65. When parts of the sealing layer SE enter the conductive apertures 65, the sealing layer SE engages with the conductive layer 60 such that the sealing layer SE can hardly be peeled off.

Next, the dummy pixels DX will be described.

The display device DSP includes a plurality of dummy pixels DX where images are not displayed, in the surrounding area SA, as shown in FIG. 5. The plurality of dummy pixels DX are provided to surround the display area DA. The plurality of electrode apertures 23 and the plurality of conductive apertures 65 are formed between the plurality of dummy pixels DX and the end portion E12 of the organic insulating layer 12.

For example, the dummy pixels DX have the same shape as the pixels PX in plan view and are provided in the same layout as the pixels PX. In the present embodiment, it is assumed that the dummy pixels DX include subpixels DP1, DP2, and DP3.

In the example shown in FIG. 5, each of the subpixels DP2 and DP3 is adjacent to the subpixel DP1 in the X-direction. Furthermore, a plurality of subpixels DP1 are arranged in the Y-direction, and the subpixels DP2 and DP3 are arranged in the Y-direction.

When the subpixels DP1, DP2, and DP3 are provided in line with this layout, a column in which the subpixels DP2 and DP3 are alternately provided in the Y-direction and a column in which a plurality of subpixels DP1 are repeatedly provided in the Y-direction are formed in the surrounding area SA. These columns are alternately arranged in the X-direction. These columns surround the display area DA. Incidentally, the layout of the subpixels DP1, DP2, and DP3 is not limited to the example in FIG. 5.

The partition 6 has a planar grating shape in an area of the surrounding area SA where a plurality of dummy pixels DX are formed. The partition 6 comprises an aperture in each of the subpixels DP1, DP2, and DP3.

In the area of the surrounding area SA where a plurality of dummy pixels DX are formed, the apertures corresponding to the pixel apertures AP1, AP2, and AP3 are not formed in the inorganic insulating layer 50 as shown in FIG. 7.

The subpixel DP1 comprises the lower electrode LE1 and the multilayer film FL1 as shown in FIG. 7. The inorganic insulating layer 50 is provided between the lower electrode LE1 and the multilayer film FL1. In other words, the organic layer OR1 (shown in FIG. 3) included in the multilayer film FL1 is not in contact with the lower electrode LE1.

The subpixel DP3 comprises the lower electrode LE3 and the multilayer film FL3 as shown in FIG. 7. The inorganic insulating layer 50 is provided between the lower electrode LE3 and the multilayer film FL3. In other words, the organic layer OR3 (shown in FIG. 3) included in the multilayer film FL3 is not in contact with the lower electrode LE3.

The sealing layers SE1 and SE3 are provided in the subpixels DP1 and DP3, respectively. The sealing layer SE1 continuously covers the multilayer film FL1, and the partition 6 around the subpixel DP1. The sealing layer SE3 continuously covers the multilayer film FL3, and the partition 6 around the subpixel DP3. In the example shown in FIG. 7, the multilayer film FL1 and the sealing layer SE1 on the partition 6 between the subpixels DP1 and DP3 are separated from the multilayer film FL3 and the sealing layer SE3 on the partition 6.

Incidentally, although not shown in FIG. 7, the subpixel DP2 comprises the lower electrode LE2 and the multilayer film FL2, and the inorganic insulating layer 50 is provided between the lower electrode LE2 and the multilayer film FL2. The sealing layer SE2 is provided in each of the subpixels DP2. The sealing layer SE2 continuously covers the multilayer film FL2, and the partition 6 around the subpixel DP2. In addition, the multilayer film FL1 and the sealing layer SE1 on the conductive layer 60 between the subpixels DP1 and DP2 are separated from the multilayer film FL2 and the sealing layer SE2 on the partition 6.

In one example, each element of the subpixels DP1, DP2, and DP3 of the dummy pixels DX is formed of the same material by the same manufacturing process as each element of the subpixels SP1, SP2, and SP3 of the display area DA.

In the subpixel DP1, an aperture is not formed in the inorganic insulating layer 50. For this reason, even if a potential difference is formed between the lower electrode LE1 and the upper electrode UE1, a voltage is not applied to the organic layer OR1 and the light emitting layer EML of the organic layer OR1 does not emit light. In the subpixels DP2 and DP3, apertures are not formed in the inorganic insulating layer 50 either. As a result, the dummy pixels DX do not display images.

Next, contact portions H1 of the inorganic insulating layer 50 will be described.

The inorganic insulating layer 50 includes a plurality of contact portions H1 in the surrounding area SA as shown in FIG. 5. The plurality of contact portions H1 penetrate the inorganic insulating layer 50 in the Z-direction as shown in FIG. 8.

The plurality of contact portions H1 are located between the plurality of dummy pixels DX and the end portion E12 of the organic insulating layer 12 in plan view. For example, the plurality of contact portions H1 are formed to surround the display area DA. Several parts of the plurality of contact portions H1 are arranged in the Y-direction in the example shown in FIG. 5. However, the layout of the plurality of contact portions H1 is not limited to this example.

The contact portions H1 have a quadrangular shape in plan view in the example shown in FIG. 5. In the other examples, the contact portions H1 may have a circular shape, an elliptical shape, or the other polygonal shape.

The contact portion H1 is larger than, for example, the conductive aperture 65 and the electrode aperture 23 in plan view. Incidentally, the contact portion H1 may be smaller than the conductive aperture 65 and the electrode aperture 23 or may have the same size as the conductive aperture 65 and the electrode aperture 23 in plan view.

The conductive layer 60 covers the electrode layer 21 via the contact portions H1. In other words, the conductive layer 60 is electrically connected to the electrode layer 21 via the contact portions H1. More specifically, the lower portion 61 of the conductive layer 60 is electrically connected to the electrode layer 21. More specifically, the bottom layer 63 of the lower portion 61 is in contact with the electrode layer 21.

The electrode layer 21 is electrically connected to a power supply line (not shown), at an end portion of the substrate 10. A common voltage is supplied to the power supply line. The conductive layer 60 is electrically connected to the upper electrodes UE1, UE2, and UE3 constituting the display elements DE1, DE2, and DE3 via the partition 6. For this reason, a common voltage is supplied from the electrode layer 21 to the upper electrodes UE1, UE2, and UE3 via the contact portions H1.

According to the display device DSP configured as described above, the yield in the manufacturing process can be improved as described below.

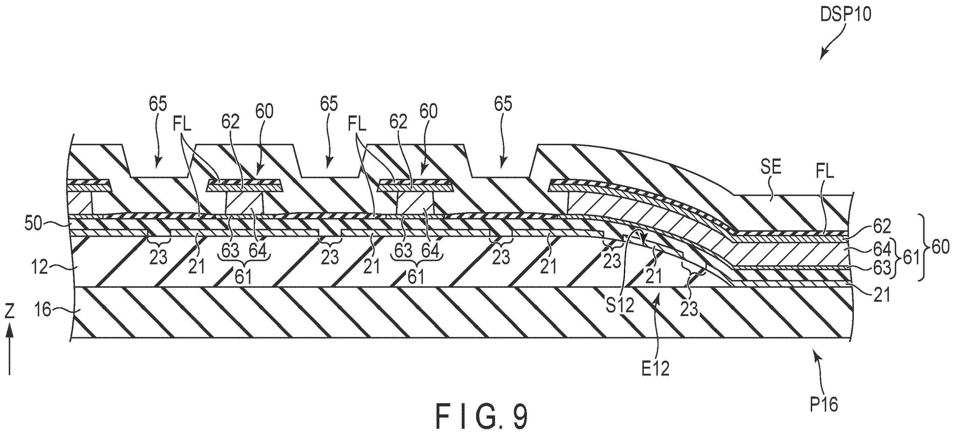

FIG. 9 is a schematic cross-sectional view showing a display device DSP10 according to a comparative example. The display device DSP10 is different from the display device DSP of the present embodiment in that the electrode apertures 23 overlap with the conductive apertures 65.

A crack may occur in the inorganic insulating layer 50 formed of an inorganic insulating material due to steps of the electrode layer 21 at edges of the electrode apertures 23. If such a crack occurs, moisture may enter the organic insulating layer 12 through the crack and the electrode apertures 23 in a process of sequentially forming the elements above the inorganic insulating layer 50 (rib 5).

In addition, a similar crack may also occur in the sealing layer SE formed of an inorganic insulating material. If cracks occur in both the inorganic insulating layer 50 and the sealing layer SE, path of moisture into the organic insulating layer 12 may also be formed in a process of patterning the sealing layer SE(for example, the sealing layer SE3) and processes subsequent to the patterning.

Moisture entering the organic insulating layer 12 may cause corrosion of the elements of the surrounding area SA and the display area DA, non-illumination of the display elements DE, and the like. For this reason, occurrence of the cracks in the inorganic insulating layer 50 and the sealing layer SE may cause the yield in the manufacturing process to be degraded.

In the display device DSP of the present embodiment, the electrode apertures 23 do not overlap with the conductive apertures 65. In other words, the conductive layer 60 is formed to cover the electrode apertures 23.

Therefore, even if a crack occurs in the inorganic insulating layer 50 in the vicinity of the electrode apertures 23, the crack is covered with the conductive layer 60. The path of moisture into the organic insulating layer 12 through the crack can be interrupted.

As a result, the yield in the manufacturing process can be improved in the display device DSP of the present embodiment. In addition, according to the present embodiment, process margin can be improved and the reliability of the display device DSP can also be improved by interrupting the path of entering moisture.

In the present embodiment, the organic insulating layer 12 has the inclined surface S12 located at the end portion E12. The electrode apertures 23 also overlap with the inclined surface S12 in plan view. The conductive layer 60 overlaps with the electrode apertures 23 overlapping with the inclined surface S12 in plan view. In contrast, the conductive apertures 65 are not formed in the area overlapping with the inclined surface S12 in plan view.

Accordingly, abnormality in shape of the conductive layer 60 can hardly occur when the conductive layer 60 is formed in the manufacturing process. As a result, the yield in the manufacturing process can be further improved according to the display device DSP of the present embodiment.

In the present embodiment, the display device DSP includes a plurality of dummy pixels DX surrounding the display area, in the surrounding area SA. Accordingly, abnormality in shape which may result from the nonuniformity in etching can hardly occur at the elements such as the partition 6 and the display elements DE1, DE2, and DE3, which are provided in the display area DA, in the manufacturing process. As a result, the yield in the manufacturing process can be further improved according to the display device DSP of the present embodiment.

All of the display devices that can be implemented by a person of ordinary skill in the art through arbitrary design changes to the display devices described above as embodiments of the present invention come within the scope of the present invention as long as they are in keeping with the spirit of the present invention.

Various types of the modified examples are easily conceivable within the category of the ideas of the present invention by a person of ordinary skill in the art and the modified examples are also considered to fall within the scope of the present invention. For example, additions, deletions or changes in design of the constituent elements or additions, omissions, or changes in condition of the processes arbitrarily conducted by a person of ordinary skill in the art, in the above embodiments, fall within the scope of the present invention as long as they are in keeping with the spirit of the present invention.

In addition, the other advantages of the aspects described in the embodiments, which are obvious from the descriptions of the present specification or which can be arbitrarily conceived by a person of ordinary skill in the art, are considered to be achievable by the present invention as a matter of course.

## Claims

1. A display device (DSP) including a display area (DA) where a plurality of display elements (DE1, DE2, DE3) are provided and a surrounding area (SA) around the display area (DA), the display device (DSP) being **characterized by** comprising:
a partition (6) provided between each adjacent pair of display elements (DE1, DE2, DE3) in the display area (DA);
an electrode layer (21) provided in the surrounding area (SA);
a conductive layer (60) provided above the electrode layer (69); and
an inorganic insulating layer (50) provided between the electrode layer (21) and the conductive layer (60), wherein
the partition (6) and the conductive layer (60) include a conductive lower portion (61) and an upper portion (62) which protrudes from side surfaces of the lower portion (61),
the electrode layer (21) includes an electrode aperture (23) penetrating in a stacking direction, and
the conductive layer (60) overlaps with the electrode aperture (23).

2. The display (DSP) device of claim 1, wherein
the conductive layer (60) includes a conductive aperture (65) penetrating in a stacking direction, and
the electrode layer (21) overlaps with the conductive aperture (65).

3. The display device (DSP) of claim 2, wherein
the electrode aperture (23) does not overlap with the conductive aperture (65).

4. The display device (DSP) of claim 2, further comprising:
an organic insulating layer (12) provided under the electrode layer (21) in the surrounding area (SA), and
the organic insulating layer (12) has an inclined surface (S12) located at an end portion (E12) of the organic insulating layer (12).

5. The display device (DSP) of claim 4, wherein
the electrode aperture (23) overlaps with the inclined surface (S12).

6. The display device (DSP) of claim 5, wherein
the conductive layer (60) overlaps with the electrode aperture (23) overlapping with the inclined surface (S12).

7. A display device (DSP) including a display area (DA) where a plurality of display elements (DE1, DE2, DE3) are provided and a surrounding area (SA) around the display area (DA), the display device (DSP) being **characterized by** comprising:
a partition (6) provided between each adjacent pair of display elements (DE1, DE2, DE3) in the display area (DA);
an electrode layer (21) provided in the surrounding area (SA);
a conductive layer (60) provided above the electrode layer (69); and
an inorganic insulating layer (50) provided between the electrode layer (21) and the conductive layer (60), wherein
the partition (6) and the conductive layer (60) include a conductive lower portion (61) and an upper portion (61) which protrudes from side surfaces of the lower portion (61),
the conductive layer (60) includes a conductive aperture (65) penetrating in a stacking direction, and
the electrode layer (21) overlaps with the conductive aperture (65).

8. The display device (DSP) of claim 7, wherein
the electrode layer (21) includes an electrode aperture penetrating in the stacking direction, and
the conductive layer (21) overlaps with the electrode aperture (23).

9. The display device (DSP) of claim 7, further comprising:
an organic insulating layer (12) provided under the electrode layer (21) in the surrounding area (SA), wherein
the organic insulating layer (12) has an inclined surface (S12) located at an end portion (E12) of the organic insulating layer (12), and
the electrode aperture (65) does not overlap with the inclined surface (S12).

10. The display device (DSP) of one of claims 2 and 7, further including:
a sealing layer (SE) provided above the conductive layer (60) and the conductive aperture (65).

11. The display device (DSP) of one of claims 1 and 7, wherein
the inorganic insulating layer (50) includes a contact portion (H1) penetrating in the stacking direction, and
the conductive layer (60) is electrically connected to the electrode layer (21) via the contact portion (H1).

12. The display device (DSP) of one of claims 1 and 7, further comprising:
a plurality of dummy pixels (DX) where images are not displayed, in the surrounding area (SA), and
the plurality of dummy pixels (DX) surround the display area (DA).

13. The display device (DSP) of one of claims 1 and 7, wherein
each of the plurality of display elements (DE1, DE2, DE3) includes a lower electrode (LE1, LE2, LE3), an upper electrode (UE1, UE2, UE3) which faces the lower electrode (LE1, LE2, LE3), and an organic layer (OR1, OR2, OR3) which is provided between the lower electrode (LE1, LE2, LE3) and the upper electrode (UE1, UE2, UE3) and emits light based on a potential difference between the lower electrode (LE1, LE2, LE3) and the upper electrode (UE1, UE2, UE3), and
the electrode layer (21) is formed of the same material as the lower electrode (LE1, LE2, LE3).

14. The display device of (DSP) claim 13, further comprising:
a rib (5) which is provided in the display area (DA) and which includes a pixel aperture (AP1, AP2, AP3) overlapping with the lower electrode (LE1, LE2, LE3), wherein
the organic layer (OR1, OR2, OR3) covers the lower electrode (LE1, LE2, LE3) through the pixel aperture (AP1, AP2, AP3), and
the rib (5) is formed of the same inorganic insulating material as the inorganic insulating layer (50) .

15. The display device (DSP) of claim 14, wherein the partition (6) is provided on the rib (5).

16. A display device (DSP) including a display area (DA) where a plurality of display elements (DE1, DE2, DE3) are provided and a surrounding area (SA) around the display area (DA), the display device being **characterized by** comprising:
a partition (6) provided between each adjacent pair of display elements (DE1, DE2, DE3) in the display area (DA);
a first organic insulating layer (12) provided in the surrounding area (SA);
an electrode layer (21) provided above the first organic insulating layer (12); and
an inorganic insulating layer (50) provided above the electrode layer (21), wherein
the partition (6) includes a conductive lower portion (61) and an upper portion (62) which protrudes from side surfaces of the lower portion (61),
the first organic insulating layer (12) has an inclined surface (S12) located at an end portion (E12) of the first organic insulating layer (12), and
the electrode layer (21) includes an electrode aperture (23) penetrating in a stacking direction and overlapping with the inclined surface (S12).

17. The display device (DSP) of claim 16, further comprising:
a conductive layer (60) which is provided above the electrode layer (21) and which includes the lower portion (61) and the upper portion (62).

18. The display device (DSP) of claim 17, wherein
the conductive layer (60) overlaps with the electrode aperture (23).

19. The display device (DSP) of claim 17, further comprising:
a plurality of dummy pixels (DX) where images are not displayed, in the surrounding area (SA), wherein
the inorganic insulating layer (50) includes a contact portion (H1) penetrating in the stacking direction,
the conductive layer (60) is electrically connected to the electrode layer (21) via the contact portion (H1), and
the contact portion (H1) is located between the plurality of dummy pixels (DX) and the end portion (E12) of the first organic insulating layer (12).

20. The display device (DSP) of claim 16, further comprising:
a second organic insulating layer (16) provided under the first organic insulating layer (12),wherein
the second organic insulating layer (16) further protrudes than the end portion (E12).

21. The display device (DSP) of claim 20, wherein
the protruding portion (P16) is covered with the electrode layer (21).
